# EUROPEAN PATENT SPECIFICATION

(11) **EP 2 855 729 B1**
(45) Date of publication and mention of the grant of the patent: **08.05.2019**
(21) Application number: 12724615.5
(22) Date of filing: 29.05.2012
(51) Int. Cl.: H01J 37/32, C23C 14/35, H01J 37/34

(54) **METHOD FOR COATING A SUBSTRATE AND COATER**
VERFAHREN ZUR BESCHICHTUNG EINES SUBSTRATS UND BESCHICHTER
PROCÉDÉ PERMETTANT DE RECOUVRIR UN SUBSTRAT ET DISPOSITIF D'ENROBAGE

(43) Date of publication of application: 08.04.2015
(73) Proprietor: Applied Materials, Inc., Santa Clara, CA 95054 (US)
(72) Inventor: SCHEER, Evelyn, 63811 Stockstadt (DE); HANIKA, Markus, 86899 Landsberg (DE); SCHWANITZ, Konrad, 63743 Aschaffenburg (DE); PIERALISI, Fabio, 63739 Aschaffenburg (DE); KLÖPPEL, Andreas, 63695 Glauburg (DE); LIU, Jian, 63538 Grosskrotzenburg (DE); LOPP, Andreas, 63579 Freigericht (DE)
(74) Representative: Zimmermann & Partner Patentanwälte mbB
(86) International application number: PCT/EP2012/060055
(87) International publication number: WO 2013/178252

(56) References cited:
- WO-A1-92/01081
- DE-A1-102009 053 609
- US-A1- 2005 252 768
- US-A1- 2007 256 933
- US-A1- 2010 181 191

## Description

### FIELD OF THE INVENTION

The present disclosure relates to a method for coating a substrate, a coater for coating a substrate, and a controller for controlling a coating process. More specifically, it relates to a method for coating a substrate and a coater for coating substrates, in particular by sputtering. More specifically, the present disclosure is directed at magnetron sputtering wherein the cathode is typically a rotatable cathode including a rotatable target. Even more specifically, the method and the coater are directed at static sputtering deposition. The present disclosure particularly relates to substrate coating technology solutions involving equipment, processes and materials used in the deposition, patterning, and treatment of substrates and coatings, with representative examples including (but not limited to) applications involving: semiconductor and dielectric materials and devices, silicon-based wafers, flat panel displays (such as TFTs), masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nano-molding.

### BACKGROUND OF THE INVENTION

In many applications, it is desired to deposit a thin layer of a coating material on a substrate. Known techniques for depositing layers are, in particular, evaporating and sputtering.

Sputtering is a vacuum coating process used to deposit thin films of various materials onto the surface of a substrate. For example, sputtering can be used to deposit a metal layer such as a thin layer of aluminium or ceramics or an oxide layer. During the sputtering process, the coating material is transported, from a target consisting of that material, to the substrate to be coated by bombarding the surface of the target with ions of an inert gas or reactive gas that are accelerated by a high voltage. When the gas ions hit the outer surface of the target their momentum is transferred to the atoms of the material so that some of them can gain sufficient energy to overcome their bonding energy in order to escape from the target surface and to deposit on the substrate. Thereon, they form a film of the desired material. The thickness of the deposited film is, inter alia, dependent on the duration of exposing the substrate to the sputtering process.

It is an ongoing desire to further improve the quality of the deposited layers. It is desired to have a high homogeneity of the layer on the substrate when coating a substrate with a layer. In particular, it is desired that the thickness of the deposited layer on the substrate is as uniform as possible throughout the whole substrate. It is further desired to have a high degree of homogeneity in terms of characteristics such as the grown crystal structure, the specific resistance, the stress of the layer, and optical characteristics. For instance, in the production of metalized layers the signal delay is dependent on the thickness of the layer so that, e.g., in the production of displays a varying thickness might result in pixels that are energized at slightly different times. It is further important to rely on a uniform layer thickness when etching a layer in order to achieve the same results at different positions. Furthermore, the costs of the deposition process shall be as low as possible.

In order to improve these characteristics of a deposited layer, it has been proposed to wobble the magnets within a rotatable cathode during sputtering. In other words, it has been suggested that the magnet of a magnetron sputter cathode is constantly moved with constant angular velocity in between certain maximum outer positions around the zero-position. Furthermore, it has been proposed that the rotatable cathode is rotated in one direction for a specific time interval, and afterwards, it is rotated in the opposite direction for the same time interval.

It turns out, however, that these measures result in a homogeneity which, dependent on the application, is still not satisfying and can still be improved upon.

### SUMMARY OF THE INVENTION

In view of the above, a method for coating a substrate and a coater for coating a substrate is provided.

According to one aspect, a method for coating a substrate by means of a cathode arrangement including at least two rotatable cathodes is disclosed. The method includes rotating at least one of the at least two rotatable cathodes in a first direction, and, at the same time, rotating at least one of the at least two rotatable cathodes in a second direction. The first direction is opposite to the second direction.

According to another aspect, a controller for controlling a coating process is disclosed. The controller is adapted for performing the method for coating a substrate by means of a cathode arrangement as disclosed herein.

According to another aspect, a coater for coating a substrate is disclosed. The coater includes a cathode arrangement with at least two rotatable cathodes and a controller as disclosed herein.

Further aspects, details, advantage and features are apparent from the dependent claims, the description and the accompanying drawings.

Embodiments are also directed to apparatuses for carrying out each of the disclosed methods and including apparatus parts for performing each described method step. These method steps may be performed by way of hardware components, a computer program by appropriate software, by any combination of the two or in any other manner. Furthermore, embodiments are also directed to methods by which the described apparatus operates or by which the described apparatus is manufactured. It includes method steps for carrying out functions of this apparatus or manufacturing parts of the apparatus.

### BRIEF DESCRIPTION OF THE DRAWINGS

So that the manner in which the features of the present disclosure are attained and can be understood in detail, a more particular description thereof, briefly summarized above, may be had by reference to the embodiments thereof, which are illustrated in the appended drawings.
Figs. 1-3 and 5-9 are schematic cross-sectional views of a coater according to embodiments disclosed herein for illustrating the method for coating a substrate according to embodiments described herein; and
Fig. 4 is a schematic cross-sectional view of a cathode assembly according to embodiments described herein.

### DETAILED DESCRIPTION OF THE DRAWINGS

Within the following description of the drawings, the same reference numbers refer to the same components. Generally, only the differences with respect to the individual embodiments are described.

The process of coating a substrate with a material as described herein refers typically to thin-film applications. The term "coating" and the term "depositing" are used synonymously herein. The term "substrate" as used herein shall include both inflexible substrates, e.g., a wafer or a glass plate, and flexible substrates, such as, webs and foils. In most cases, the substrate is an inflexible substrate, such as, a glass plate, e.g., used in the production of a display. The typical coating process used in embodiments described herein is sputtering.

Generally, sputtering can be undertaken as diode sputtering or magnetron sputtering. The magnetron sputtering is particularly advantageous in that its deposition rates are rather high. Typically, at least one magnet is positioned within the rotatable cathode, for instance, one magnet or two magnets. According to embodiments, the magnet is movably arranged within the rotatable cathode. The rotatable cathode as used herein is typically a rotatable curved cathode including a rotatable curved target. By arranging the magnet inside of the cathode in the event of a rotatable cathode, in order to trap the free electrons within the generated magnetic field, which is generated directly below the target surface, these electrons are forced to move within the magnetic field and cannot escape. This enhances the probability of ionizing the gas molecules typically by several orders of magnitude. This, in turn, increases the deposition rate significantly.

Generally, the substrate may be continuously moved during coating ("dynamic coating") or the substrate to be coated rests during coating ("static coating"). Static coating is advantageous in that the amount of target material used up for the coating is smaller in comparison to dynamic coating since in the latter case the substrate holders are often coated as well. Static coating particularly allows the coating of large-area substrates. The substrates are entered into a coating area, the coating is performed, and the substrates are taken out of the coating area again. The present disclosure specifically relates to static coating.

Sputtering can be used in the production of displays. In more detail, sputtering may be used for the metallization such as the generation of electrodes or buses. It is also used for the generation of thin film transistors (TFTs), such as in LCD applications. It may also be used for the generation of transparent conductive layers, such as an ITO (indium tin oxide) layer, in particular for colour filter applications and/or pixel ITO applications. For instance, the deposited layer may be configured to form the lower electrode of a TFT stack.

Sputtering can also be used in the production of thin-film solar cells. Generally, a thin-film solar cell comprises a back contact, an absorbing layer, and a transparent and conductive oxide layer (TCO). Typically, the back contact and the TCO layer is produced by sputtering whereas the absorbing layer is typically made in a chemical vapour deposition process.

In comparison to an evaporation process such as chemical vapour deposition, sputtering is advantageous in that there are materials which can be sputtered but cannot be evaporated. Further, the adhesion of the produced layers to the substrate is typically stronger in sputtering processes than in evaporation processes. Further, sputtering is a directional process so that the major part of the material is transferred to the substrate and does not coat the interior of the deposition apparatus (as in evaporation applications). The present disclosure specifically relates to sputtering.

Accordingly, the coater as described herein is typically a sputter apparatus and the rotatable cathodes are rotatable sputter cathodes. The plurality of rotatable cathodes provided according to aspects of the present disclosure shall be called "cathode arrangement" herein. The term "cathode" and "cathode assembly" shall be used synonymously herein.

The term "magnet assembly" or "magnet" as used herein is a unit capable of generating a magnetic field. Typically, the magnet assembly consists of a permanent magnet. This permanent magnet is typically arranged within the rotatable cathode. In many embodiments, the magnet assembly comprises a magnet yoke. By moving the magnet assembly within the cathode, more particularly by rotating the magnet assembly along the axis of the rotatable cathode as rotational center, the sputtered material can be directed in different directions. In particular in combination with a movement of the magnet assembly, the voltage or the power applied to the rotatable cathode may be varied over time. That is, a non-constant voltage or a non-constant power may be applied to the rotatable cathode according to embodiments.

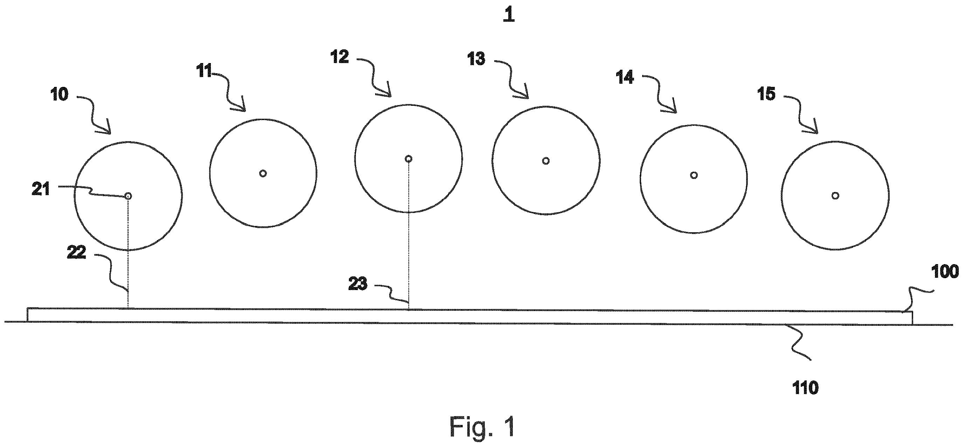

Fig. 1 schematically illustrates a substrate 100 being positioned on a substrate holder 110. The cathode arrangement 1 is illustrated as including an array of rotatable cathodes, namely, six rotatable cathodes 10, 11, 12, 13, 14, and 15 positioned adjacent to the substrate 100 in a sequence. A negative potential as compared to the potential at the substrate may be applied to the rotatable cathodes. Alternatively, the housing serves as the anode.

Within the present disclosure, the figures illustrate cross sectional schematic views of coaters along with exemplarily shown substrates. Typically, the rotatable cathodes have the shape of a cylinder. In other words, the cathode extends into the paper and out of the paper when looking at the drawings. The same is true with respect to the magnet assemblies discussed later on that are also only schematically shown as cross sectional elements. The magnet assemblies may extend along the complete length of the cylinder. For technical reasons, it is typical that they extend along at least 80 % of the cylinder length, more typically along at least 90 % of the rotatable cathodes' length.

According to embodiment described herein, the number of rotatable cathodes in an array of rotatable cathodes is an even number, for instance, two, four, six, eight, ten, twelve, fourteen etc. As will be described in more detail below, every two of the adjacent rotatable cathodes can be linguistically combined and called "a pair of rotatable cathodes". When referring to a pair of rotatable cathodes as used herein it is understood that the two rotatable cathodes of the pair of rotatable cathodes are positioned adjacent to each other. Hence, sometimes they may also be referred to as "a pair of adjacent rotatable cathodes".

When referring to the rotation of a rotatable cathode it shall be understood that the outer part of the rotatable cathode, that is, the target, is rotatable. As will be discussed in more detail below, this might also include that further parts of the rotatable cathode, such as the backing tube, are rotatable. However, some parts of the rotatable cathode are typically not adapted to be rotated. These parts shall be referred to as the "inner part" of the rotatable target.

The rotatable cathodes are rotatable along their longitudinal axes. According to the presently described embodiments, each of the rotatable cathodes can be rotated in a first direction (such as the clockwise direction) or the second direction (such as the counter-clockwise direction). The first direction is the rotation direction opposite to the second direction. According to aspects described herein, at least one rotatable cathode rotates in the first direction meanwhile at least one rotatable cathode rotates in the second direction. Typically, if an even number of rotatable cathodes is provided, the number of rotatable cathodes rotating in the first direction equals the number of rotatable cathodes rotating in the second direction.

Alternatively, the number of rotatable cathodes in an array may also be an uneven number, such as nine, eleven, thirteen or fifteen. If an uneven number of rotatable cathodes are provided, such as *2n*+*1* rotatable cathodes, it is typical that *n* rotatable cathodes rotate in the first direction whereas *n*+*1* rotatable cathodes rotate in the second direction. The influence of the outermost rotatable cathode (which is typically the *2n*+*1-*th rotatable cathode) on the substrate homogeneity and uniformity is smaller as compared to rotatable cathodes positioned closer to the substrate's center because, according to embodiments, the one or two outermost rotatable cathodes might be positioned in a protruding manner adjacent to the substrate in order to reduce edge effects during sputtering.

If herein the rotatable cathodes are described to as rotating in opposite directions this shall be understood as that they rotate so at the same time (and thus not subsequently).

For instance, the coater as illustrated in Fig. 1 includes six rotatable cathodes 10-15. It shall be understood that this is for exemplary purposes, and the coater might also include more or less than six rotatable cathodes, such as ten. According to embodiments, each of the rotatable cathodes has one neighbouring rotatable cathode (such as the rotatable cathodes 10 and 15 in Fig. 1) or two neighbouring rotatable cathodes (such as the rotatable cathodes 11, 12, 13, and 14 in Fig. 1). The term "neighbouring" shall be used to mean "adjacent" herein. It shall refer to the rotatable cathode(s) next to the rotatable cathode under consideration. For instance, the neighbouring cathodes of rotatable cathode 12 are rotatable cathodes 11 and 13.

According to typical embodiments not limited to the illustration of Fig. 1, each rotatable cathode rotates in a direction that is opposite to the rotational direction of its one or two neighbours. For instance, in the illustration of Fig. 1, the rotatable cathodes may rotate in an alternating manner, that is, the rotatable cathodes 10, 12, and 14 could rotate in the first direction, whereas, at the same time, the rotatable cathodes 11, 13, and 15 may rotate in the second direction, i.e., in an opposite direction to the first direction. Alternatively, it is possible that a number of neighbouring rotatable cathodes rotate in the first direction, and the rest of the cathode arrangement rotates, at the same time, in the opposite direction, for instance, the rotatable cathodes 10, 11, and 12 may rotate in the first direction, whereas at the same time the rotatable cathodes 13, 14, and 15 rotate in the second direction. Alternatively, it is possible that the rotatable cathodes 10, 11, and 14 rotate in the first direction, whereas at the same time the rotatable cathodes 12, 13, and 15 rotate in the second direction.

According to typical embodiments, the rotation direction of the at least one rotatable cathode is not altered during the coating process. Typically, the rotational direction of all rotatable cathodes is not altered during the coating process. The coating process as understood herein may include or consist of the coating of one substrate.

The rotation speed of the rotatable cathodes may be constant, such as for the complete sputtering process. Alternatively, the rotation speed of one or more of the rotatable cathodes may be non-constant. Either way, it is typical that the rotation speed of all rotatable cathodes of the cathode arrangement is identical, notwithstanding the rotation direction.

Furthermore, as illustrated in various figures explained herein and applicable to all embodiments described herein, the distance of the rotatable cathodes to the substrate may be different. Typically, the term "distance" between cathodes as understood herein refers to the distance between center axis and center axis of the cathodes.

For instance, the distance of the rotatable cathodes, that are positioned closer to the substrate's edges, to the substrate may be smaller than the distance of the rotatable cathodes positioned further away from the substrate's edges (i.e., towards or in the center of the substrate). The distance as understood in this context is the length of a virtual line leading from the axis of the rotatable cathode to the substrate whereas the virtual line hits the substrate's surface in a perpendicular manner.

Such an arrangement with different distances between substrate 110 and the cathodes is illustrated in Figs. 1-5 and Fig. 7. In particular, in Fig. 1 the center axis of the rotatable axis is denoted with reference number 21. The outermost rotatable cathode 10 is positioned closest to the substrate, namely, at a distance that is illustrated by the dotted line 22. Compared thereto, the rotatable cathode 11 is positioned further away from the substrate, and the rotatable cathode 12 is positioned furthest away from the substrate, namely, at a distance illustrated by the dotted line 23.

Generally, and not limited to any embodiment, the ratio of the distance of the one or more targets positioned closest to the substrate (e.g., targets 10 and 15 in Fig. 1) to the distance of the one or more targets positioned furthest away from the substrate (e.g., targets 12 and 13 in Fig. 1) may be in the range of 0.6 to 0.8. For instance, the cathodes furthest away from the substrate may be arranged at a distance of between 170 mm and 250 mm. Additionally or alternatively, the cathodes closest to the substrate may be arranged at a distance of between 110 mm and 200 mm.

As briefly discussed already, known deposition techniques partly result in non-uniformities in thickness, in particular in the vertical direction. This is sometimes referred to as "left-to-right drift". Furthermore, the non-uniformities result in extensive resistance distributions over the substrate. There may even be a slope of thickness over the substrate.

It had been proposed to alter the depositional direction of a target during sputtering in order to improve the deposition homogeneity. This resulted in an improvement of the homogeneity, however, an increased overall deposition time due to the interruption of the sputtering process when changing the rotation direction was also incurred. Furthermore, the wear on the target rotation drives increased resulting in higher maintenance costs increased down times.

According to an aspect of the present disclosure, the coating process is not interrupted. Instead, throughout the deposition, a selectable number of rotatable cathodes rotate in one direction whereas a selectable number of rotatable cathodes rotate in the opposite direction. Typically, the rotatable cathodes rotate in an opposite direction in an alternating manner, for instance, every second rotatable cathode rotates in the first direction, and the rotatable cathodes between every second rotatable cathode rotate in the second direction. The rotatable cathodes are typically arranged in an array in a manner so as to face a substrate, as illustrated in all the figures. However, as discussed already, the distance between each rotatable cathode and the substrate might differ.

The inventors of the present application found out that the proposed method of coating leads to an improved homogeneity and thus to an improved resistance distribution over the substrate. The typical sputter materials are IO (Indium-Oxide), ITO (Indium-Tin-Oxide), IZO (Indium-Zinc-Oxide), IGZO (Indium-Gallium-Zinc-Oxide). Those materials may be sputtered in a partly reactive manner. Furthermore, the target may be comprised of metals such as Cu (copper), Molybdenum (Mo) and Titanium (Ti). Those materials may be sputtered in a nonreactive manner.

The reactive sputter processes may provide deposited oxides of the target materials, such as, of the target materials listed. However, nitrides or oxi-nitrides might be deposited as well. According to yet further embodiments, the target material can also be selected from the group consisting of aluminium (for instance, thereby generating A1₂0₃), silicon, tantalum and niobium.

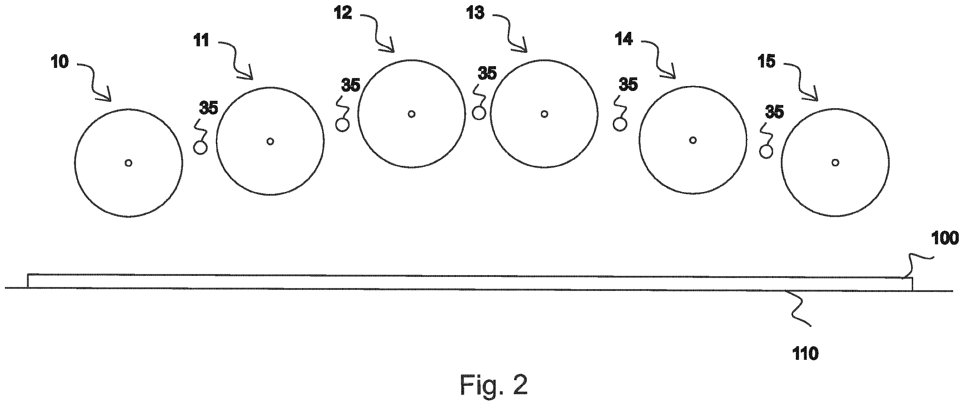

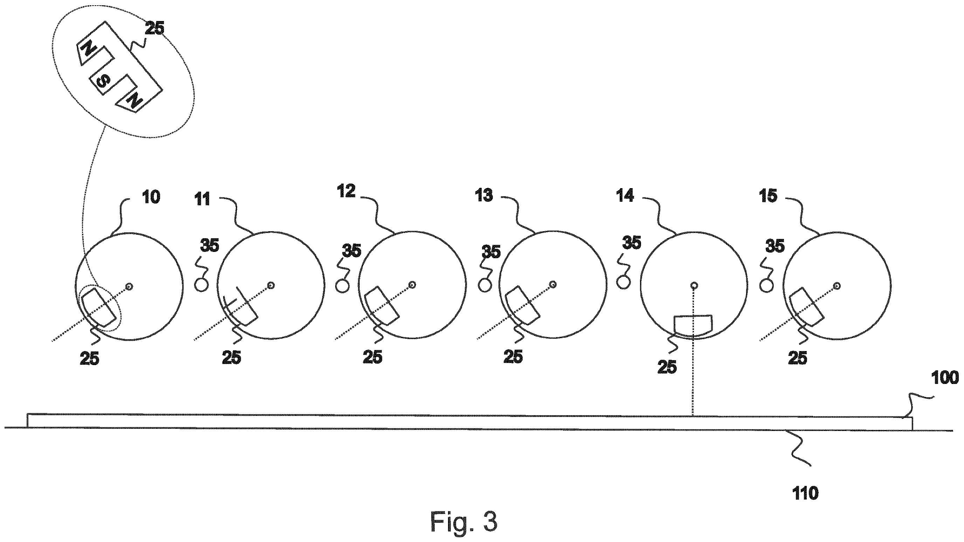

Fig. 2 illustrates an embodiment including anodes 35. A positive potential is applied to the anodes, and they are positioned between the rotatable cathodes. As shown, and not limited to the embodiment of Fig. 2, the anodes may be provided between each of the neighbouring rotatable cathodes. Such an anode may generally have the shape of a bar, with the bar's axis being typically arranged in parallel to the axis of the angular tube. In other embodiments, a separate bias voltage may be applied to the substrate. The provision and use of the anodes is possible with all embodiments described herein, however, for reasons of clarity, the anodes are explicitly depicted only with respect to Figs. 2 and 3. In particular, the anodes may be provided in between pairs of cathodes that will be discussed later on in more detail.

Fig. 3 illustrates an embodiment wherein the magnet assemblies 25 are schematically shown located within the rotatable cathodes 10-15. A typical permanent magnet as used in embodiments described herein has two north magnetic poles and a south magnet pole. These poles refer each to a surface of the magnet assembly. The surfaces typically face the rotatable cathode from its inside. According to the illustrated example, the cathodes are arranged at the same distance with respect to the substrate surface. Furthermore, the cathodes are exemplarily illustrated as having the identical distance to each other. Any combination of these features is possible according to embodiments described herein.

Although not explicitly illustrated in Fig. 3, the cathodes of the embodiment of Fig. 3 could also be arranged on an arc, as exemplarily described with respect to Figs. 1, 2, 6, 7, and 9. The number of cathodes may be any other number than six, for instance, ten. The description of the magnets as illustrated in Fig. 3 is also applicable to all other embodiments described herein, in particular with respect to the embodiments having pairs of cathodes. Furthermore, the anodes 35 shown in Fig. 3 are not mandatory but other types of anodes can generally be employed.

In many cases, one pole is positioned in the middle whereas two opposite poles are arranged adjacent to it. In Fig. 3, an enlargement of the magnet assembly 25 is shown for illustrating such a situation. As shown, the south pole is positioned in the middle, whereas the north poles enframe the south poles. The pole surfaces' shape may be adapted to the curvature of the rotatable curved target they are positioned in.

The substrate's surface defines a plane; the cross-section of which is shown in the figures. The orientation of the substrate spatially can be horizontal or vertical. In particular, in view of a large-area coating, it might simplify and ease transportation and handling of a substrate if the substrate is oriented vertically. Therefore, herein, the term "vertical" refers to the plane of the substrate. In other embodiments, it is even possible to arrange the substrate somewhere between a horizontal and a vertical orientation.

The present disclosure is particularly directed at large area substrate coatings. The embodiments described herein can be utilized for Display PVD, i.e. sputter deposition on large area substrates for the display market. According to some embodiments, large area substrates or respective carriers, wherein the carriers have a plurality of substrates, may have a size of at least 0.67 m². Typically, the size can be about 0.67 m² (0.73x0.92m - Gen 4.5) to about 8 m², more typically about 2 m² to about 9 m² or even up to 12 m². Typically, the substrates or carriers, for which the structures, apparatuses, such as cathode assemblies, and methods according to embodiments described herein are provided, are large area substrates as described herein. For instance, a large area substrate or carrier can be GEN 4.5, which corresponds to about 0.67 m² substrates (0.73x0.92m), GEN 5, which corresponds to about 1.4 m² substrates (1.1 m x 1.3 m), GEN 7.5, which corresponds to about 4.29 m² substrates (1.95 m x 2.2 m), GEN 8.5, which corresponds to about 5.7 m² substrates (2.2 m x 2.5 m), or even GEN 10, which corresponds to about 8.7 m² substrates (2.85 m × 3.05 m). Even larger generations such as GEN 11 and GEN 12 and corresponding substrate areas can similarly be implemented.

Additionally to the described method of rotating the rotatable cathodes, the magnet assembly 25 may be moved within the rotatable cathode. This is illustrated in Fig. 3 wherein each magnet assembly 25 in the rotatable cathodes 10, 11, 12, 13, and 15 is depicted, for illustrative purposes, in the outer positions within the rotatable cathode, and wherein the magnet assembly 25 in the rotatable cathode 14 is, for illustrative purposes, depicted in the zero angle position. The movement of the magnet assembly may be a steady movement, for instance oscillating between two outer positions (such as between the two outer positions, one of which is shown in the cathodes illustrated in Fig. 3), or the movement may include a resting time of the magnet assembly.

For instance, the magnet assembly may remain at a position other than a zero angle position for a predetermined time interval. It shall be noted that the phrase "positioning the magnet assembly off from the zero angle position for a selectable time interval" shall be understood as positioning the magnet assembly off from the zero angle position and keeping it at exactly this position for some time. Within the present disclosure, the zero angle position shall be defined as the position within the rotatable cathode that is closest to the substrate. Typically, this predetermined time interval is larger than 0.1 sec, more typically 1 sec, more typically larger than 10 sec, and even more typically larger than 30 sec. The zero angle position of the magnet assembly shall be understood as the position within the rotatable cathode that is closest to the substrate. In the embodiment of Fig. 3, the zero angle position is illustrated by the magnet assembly 25 positioned in the rotatable cathode 14.

The combined method of rotating at least two rotatable cathodes in opposite directions during the sputtering process and positioning the magnet assembly off from the zero angle position, such as oscillating ("wobbling") the magnet assembly within the rotatable cathode during sputtering, has proven to be very beneficial for the resulting layer properties.

According to aspects of the present disclosure, the magnet assembly is positioned at a non-zero angle position within the rotatable cathode for a predetermined time interval. For instance, the magnet assembly 25 may be positioned at an angle of -α with respect to the zero angle position for a selectable time interval and it is then moved to a second non-zero angle position, such as at an angle of +α with respect to the zero angle position for a selectable time interval. The values of +α and -α shall illustrate that the first position of the magnet assembly typically corresponds to a second position mirrored at a virtual plane leading through the axis of the cathode and the zero angle position. A negative angle shall refer to a deflection to the left whereas a positive angle shall refer to a deflection to the right as described herein. Typical absolute values of the angle α are up to 35°, more typically up to 25° or only 15°.

Positioning the magnet assembly at a non-zero angle position results in that the plasma is not generated at the area over the target surface that is closest to the substrate but at an area arranged laterally. Thus, the sputter variance is increased so that a tilted position of the magnet assembly may result in a higher coating rate of areas that are not supposed to be coated such as the substrate holder or walls within the coating room. In other words, it may thus result in a reduced efficiency. Despite this situation, it has been found out that the homogeneity of the deposited layer on the substrate could be increased by positioning the magnets off from the zero angle position whilst, at the same time, rotating the rotatable cathodes in opposite directions. When talking about the homogeneity of the layer, this shall be mainly understood as the uniformity of the layer thickness throughout the coated area on the substrate, the crystal structure, the specific resistance, and the stress of the layer.

As already set forth, it is typical to position the magnet assembly in a first and a second position wherein the second position has the identical absolute value of the angle but mirrored at the substrate-target interconnection plane.

As understood herein, the rotatable target of the rotatable cathode may be supported by a backing tube to which the rotatable target is mounted. The material of the rotatable target is configured to be cleared away during the sputtering process and is deposited on the substrates that are coated. In order to reduce the high temperatures on the target that result from the sputtering process, in many embodiments the rotatable cathode is provided with a cooling material tube in its inside. Typically, water is used as cooling material. Cooling is necessary because the major part of the power put into the sputtering process - typically in the order of magnitude of some kilo Watts - is transferred into heat of the target. For instance, the complete inner part of the target tube is filled with cooling material such as water.

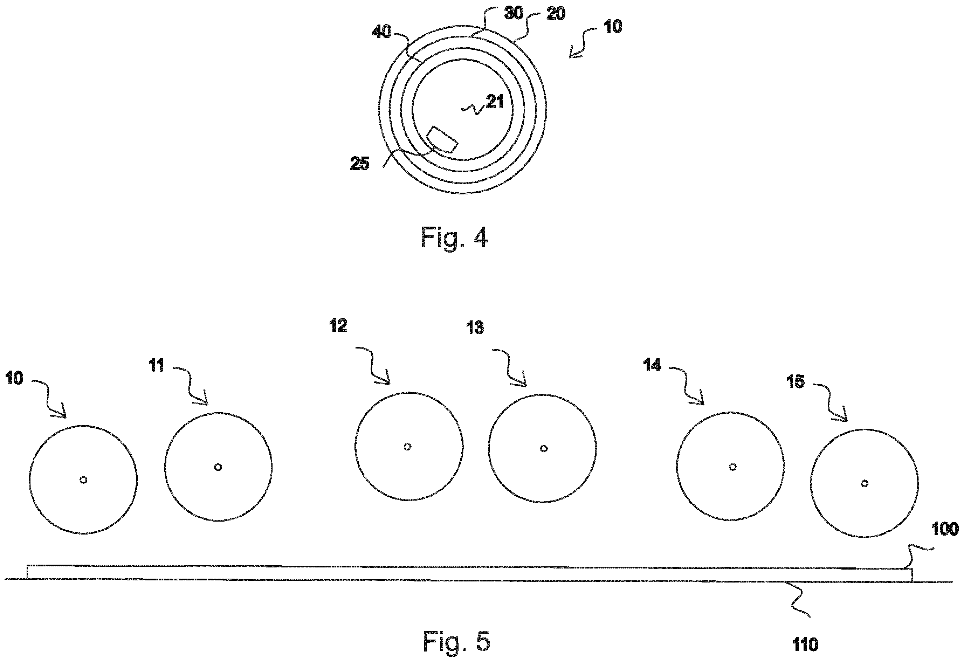

Fig. 4 exemplarily illustrates a rotatable cathode as used in embodiments described herein in more detail. It is to be understood that all the elements shown in Fig. 4 may be applied in all the embodiments described herein. As illustrated in Fig. 4, the rotatable cathode includes the following elements. The rotatable target 20 is placed on a backing tube 30. Typically, the rotatable target 20 is a tube. The backing tube 30 is mainly for mounting the rotatable target 20, the material of which is supposed to be cleared away during sputtering, such as, by bonding or gluing. The backing tube 30 may be omitted in some embodiments.

In order to reduce the high temperatures of the target that results from the sputtering process, in many embodiments, the rotatable target 20 includes a cooling material tube 40 in its inside. The cooling material tube is typically positioned co-axially to the target tube. Typically, water is used as cooling material. Cooling is necessary because the major part of the energy put into the sputtering process is transferred into heat of the target. As shown in the schematic view of Fig. 4, the magnet assembly 25 is positioned within the backing tube 30 and the cooling material tube 40 so that it can move therein to different angle positions if desired. According to other embodiments, the complete inner part of the target tube is filled with cooling material such as water.

Generally, and not limited to the embodiment of Fig. 4, the magnet assembly 25 may be mounted on the axis 21 of the rotatable cathode 10. A pivoting movement of the magnet assembly 25 as described herein may be caused by an electromotor providing the necessary rotational force. In typical embodiments, the cathode assembly is equipped with two shafts (not shown in Fig. 4). A first shaft which the rotatable target 20 is mounted on;the first shaft is rotated in operation of the cathode assembly as described herein. The movable magnet assembly 25 is typically mounted to the second shaft. The second shaft moves independently from the first shaft, typically in a manner so as to allow the movement of the magnet assembly 25 as described herein.

According to embodiments, the movement of the magnet assemblies is undertaken at a high speed so that the overall movement time is in the range of below 1 sec, more typically below 0.5 sec. It is further possible to switch off the voltage applied to the target at the time of movement which might further increase the uniformity in some embodiments. Hence, typically, the potential applied is synchronized with the positioning of the magnet assembly. For instance, the potential could drop during movement of the magnet assembly to a value of maximally 35%, more typically maximally 20% of the maximum potential value.

According to aspects described herein, the distance between neighbouring rotatable cathodes may be different. In particular, some neighbouring rotatable cathodes may have a first distance to each other whereas other rotatable cathodes may have a second distance to each other whereas the first distance is larger than the second distance. This arrangement of the multitude of rotatable cathodes provides some benefits that will be discussed below. It shall be called "non-equidistant positioning of rotatable cathodes" herein, and shall be further illustrated in view of exemplary embodiments depicted in Figs. 5-8.

In addition to the beneficial effects of the different rotation direction of the rotatable cathodes as described, it has been found out by the inventors that the gradient in fundamental layer properties, such as electrical and optical properties (e.g., resistance of the layer, transmission properties etc.) over the width of the coated substrate can be further reduced by the following arrangement and method of sputtering. Herein, the term "width" of the substrate is understood as being perpendicular to the axial extension of the rotatable cathodes.

The disclosed arrangement and method for sputtering shall be exemplarily described in view of the following figures. In Fig. 5, six rotatable cathodes 10 to 15 are depicted, however, in contrast to the figures illustrated so far, in the embodiment of Fig. 5 they are positioned in a non-equidistant manner. More particularly, and not limited to the embodiment of Fig. 5, it is possible that each two neighbouring rotatable cathodes are positioned closer to each other and thus shall be understood as a "pair" of rotatable cathodes herein. Each pair of rotatable cathodes, however, is positioned further away from the next neighbouring pair of rotatable cathodes as compared to the distance between the cathodes within a pair. According to typical embodiments, per each pair of neighbouring rotatable cathodes, one of the rotatable cathodes rotates in one direction and the other rotatable cathode rotates in the opposite direction.

Typically, the ratio of the distance difference between two cathodes within a pair of cathodes to the distance between two neighbouring pairs is between 0.80 and 0.98, more typically, between 0.85 and 0.96. For instance, the distance between the cathodes of a pair may be in the range of between 230 mm and 280 mm, such as between 240 mm and 270 mm. The distance between two neighbouring cathodes within a pair of cathodes may be in the range of 210 mm and 260 mm, such as between 220 mm and 250 mm (all distances measured from center axis to center axis).

It has been found out by the inventors that this way of positioning the rotatable cathodes benefits from the aforementioned effects regarding the improvement of the uniformity of the sputtered layer and the reduction of the resistance variance. In addition, since due to the increased distance between the pairs of cathodes the overall need of cathodes is reduced as compared to an equidistant positioning, the number of cathodes provided can be reduced so that the production costs can be reduced.

An example of three pairs, including six rotatable targets shall be explained in view of Fig. 5. Therein, the rotatable cathodes 10 and 11, 12 and 13, 14 and 15 each form a pair of rotatable cathodes. Generally, with n rotatable cathodes, it is typical to have n/2 pairs of rotatable cathodes. Only neighbouring rotatable cathodes can be understood as pairs within the present disclosure. A pair includes typically two rotatable cathodes.

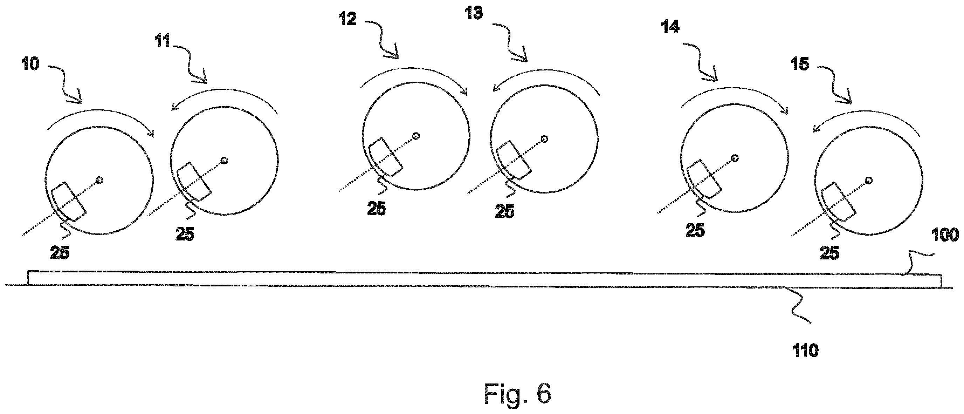

Further to the exemplary arrangement of Fig. 5, the embodiment of Fig. 6 furthermore illustrates the magnet assemblies 25. The magnet assemblies may be wobbled or positioned off the zero angle as described previously.

For illustrative purposes, exemplary rotational directions of the rotatable cathodes are illustrated by arrows in Fig. 6. Whereas it is irrelevant which rotatable cathode rotates in the clockwise or counter-clockwise direction, it is of relevance for the discussed embodiments that the two rotatable cathodes of each pair each rotate in an opposite direction to the rotation direction of the other cathodes of the same pair. In the exemplary embodiment of Fig. 6, the rotatable cathodes of the array of rotatable cathodes are rotated in an alternating manner, that is, each rotatable cathode rotates in the opposite direction to its neighbouring rotatable cathodes.

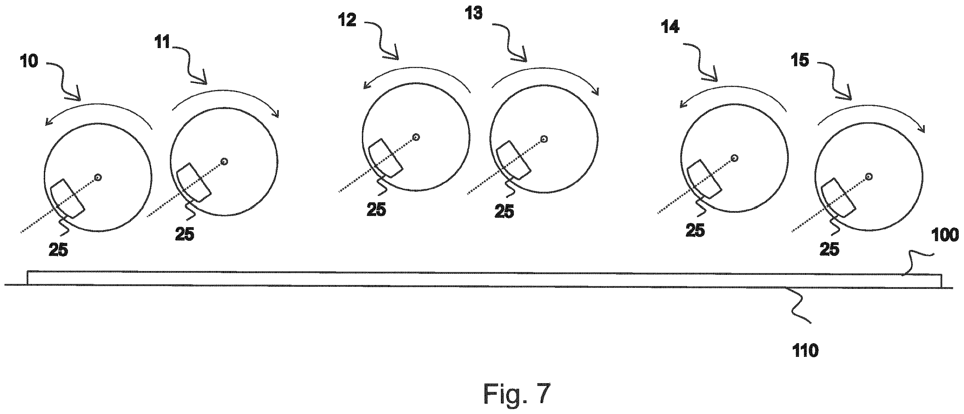

Fig. 7 illustrates the same coater as the embodiment of Fig. 6. As depicted by the arrows, the coater is operated differently in that the rotational direction is opposite to the rotational direction illustrated in Fig. 6. However, as in many embodiments described herein, and in particular as illustrated in Fig. 6, the cathode arrangement includes a multitude of pairs of rotatable cathodes wherein each rotatable cathode in each pair rotates in an opposite direction to the other rotatable cathode of the same pair.

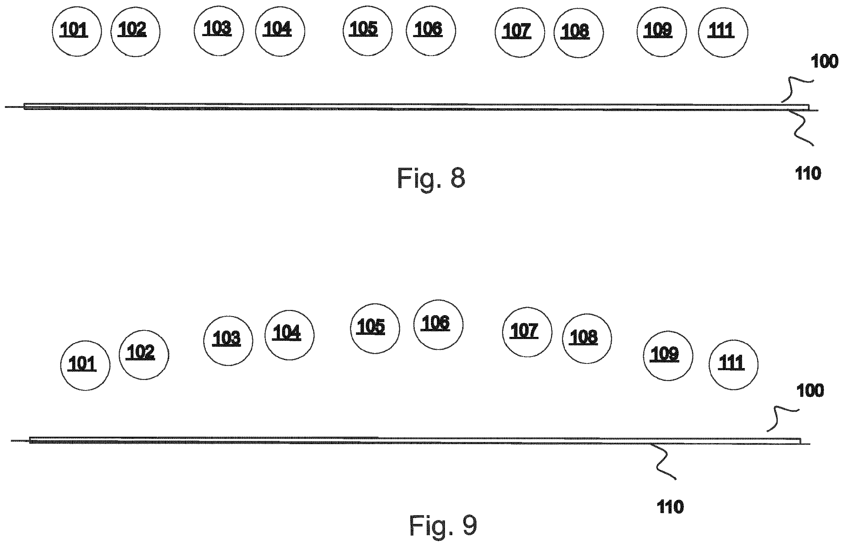

Fig. 8 shows an embodiment wherein ten rotatable cathodes 101-109, 111 are provided in a pair-wise manner as described. Whereas they are all arranged at the same distance to the substrate in the embodiment of Fig. 8, the ten rotatable cathodes 101-109, 111 arranged in a pair-wise manner, are positioned at different distances to the substrate. It is possible that the rotatable cathodes within one pair have the same distance to the substrate, or the rotatable cathodes within one pair have different distances to the substrate.

According to typical embodiments, the distance between two rotatable cathodes in a first pair of rotatable cathodes and the distance between two rotatable cathodes in a second pair of rotatable cathodes is identical. This is also illustrated in Figs. 5-9 wherein each pair of rotatable cathodes is provided with two rotatable cathodes positioned away from each other at the identical distance. Alternatively or additionally, the distance between neighbouring pairs of cathodes may be identical for the complete cathode arrangement.

It is further typical that the length of the rotatable cathode is slightly larger than the length of the substrate to be coated. Furthermore, the array of rotatable cathodes (i.e. the multitude of rotatable cathodes) may be slightly broader than the width of the substrate. "Slightly" typically includes a range of between 100% and 110%. The provision of a slightly larger coating length/width helps avoiding boundary effects.

As illustrated in various figures, the multitude of rotatable cathodes is arranged at a different distance to the substrate. They might be arranged along an arc's shape. The shape of the arc may be such that the inner rotatable cathodes are located closer to the substrate than the outer cathode assemblies. Such a situation is schematically shown in Figs. 1, 2, 3, 5, 6, 7 and 9. Alternatively, it is also possible that the shape of the arc defining the positions of the multitude of cathode assemblies is such that the outer cathode assemblies are located closer to the substrate than the inner cathode assemblies. The scattering behaviour depends on the material to be sputtered. Hence, depending on the application, i.e. on the material to be sputtered, providing the cathode assemblies on an arc shape will further increase the homogeneity. The arc shape typically belongs to a virtual circle with a typical radius of at least 10 m, such as 15 m.

In addition to the embodiments described herein, it is alternatively or additionally possible to wobble the substrate. The term "wobbling" the substrate shall be understood as moving the substrate back and forth within a limited distance. Typically, the substrate is positioned at a first position for a predetermined time interval, and it is positioned at a second position for a predetermined time interval. In further embodiments, the substrate may additionally be positioned at a third position and a fourth position.

The present disclosure allows an improvement in coating quality in terms of an increased layer uniformity and thus homogenized electrical and optical properties of the deposited layers.

Furthermore, according to some embodiments described herein, as mentioned already, the non-equidistant arrangement of rotatable cathodes allows saving sputter targets which decreases the hardware costs for, for instance, anodes, drives, water cooling, power supplies and cost of operation of the coater. For instance, a cathode arrangement with twelve cathodes arranged in a equidistant manner might comparably be provided with ten cathodes arranged in a non-equidistant manner. The gradient of electrical and optical layer properties like sheet resistance and optical transmission can further be reduced or even avoided. In addition, the deposition times can be reduced and the wear on the rotatable cathode drives can be reduced. Moreover, due to the increased distance between pairs of rotatable cathodes, the crosstalk of electrons between targets, known as cross corner effect, can be decreased, which increases target lifetime in the array.

While the foregoing is directed to embodiments of the invention, other and further embodiments of the invention may be devised without departing from the basic scope thereof, and the scope thereof is determined by the claims that follow.

This written description uses examples to disclose the invention, including the best mode, and also to enable any person skilled in the art to make and use the invention. While the invention has been described in terms of various specific embodiments, those skilled in the art will recognize that the invention can be practiced with modification within the spirit and scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A method for coating a substrate by means of a cathode arrangement including at least two rotatable, cylindrical cathodes, the method comprising:
a) rotating at least one of the at least two rotatable cathodes in a first direction; and,
b) at the same time, rotating at least one of the at least two rotatable cathodes in a second direction;
wherein the first direction is opposite to the second direction; and
wherein the at least two rotatable cathodes include a first pair of rotatable cathodes, wherein the first pair consists of two neighbouring rotatable cathodes, and a neighbouring second pair of rotatable cathodes, wherein the second pair consists of two neighbouring rotatable cathodes,
wherein the rotational direction of one of the two rotatable cathodes of the first pair of rotatable cathodes is opposite to the rotational direction of the other one of the two rotatable cathodes of the first pair of rotatable cathodes, and
wherein the rotatable cathodes are positioned on a circumferential line of an arc including a first radius.

2. The method according to claim 1, wherein the cathode arrangement includes at least four rotatable cathodes.

3. The method according to any of the preceding claims, wherein the cathode arrangement includes an even number of rotatable cathodes, wherein a first half of the at least two rotatable cathodes is rotated in the first direction, and a second half of the at least two rotatable cathodes is rotated in the second direction.

4. The method according to any of claims 2-3, wherein the at least four rotatable cathodes are rotated in opposite directions in an alternating manner.

5. The method according to any of claims 2-4, wherein the distance between at least two neighbouring rotatable cathodes differs from the distance between at least two other neighbouring rotatable cathodes.

6. The method according to any of the preceding claims, wherein the rotation direction of one of the two rotatable cathodes of the second pair of rotatable cathodes is opposite to the rotation direction of the other one of the two rotatable cathodes of the second pair of rotatable cathodes

7. The method according to any of claims 1 to 6, wherein the distance of the two rotatable cathodes of the first pair of rotatable cathodes and optionally the distance of the two rotatable cathodes of the second pair of rotatable cathodes differs from the distance between the first pair of rotatable cathodes and the second pair of the rotatable cathodes.

8. The method according to any of claims 1 to 7, wherein the distance of the two rotatable cathodes of the first pair of rotatable cathodes and the distance of the two rotatable cathodes of the second pair of rotatable cathodes is identical.

9. The method according to any of the preceding claims, wherein the at least two rotatable cathodes each include at least one magnet assembly positioned there within, the method further comprising:
a) positioning the magnet assembly with respect to the rotatable cathode at a first position so that the magnet assembly is asymmetrically aligned with respect to a plane perpendicularly extending from the substrate to the axis of the rotatable cathode for a predetermined first time interval; and
b) moving the magnet assembly to a second position that is also asymmetrically aligned with respect to said plane and keeping the magnet assembly at the second position for a predetermined second time interval.

10. The method of claim 10, wherein the magnet assemblies in each rotatable cathode of the first pair of rotatable cathodes and/or the second pair of rotatable cathodes are positioned and moved synchronously.

11. A coater for coating a substrate, comprising:
a) a cathode arrangement including at least two rotatable cathodes positioned on a circumferential line of arc including a first radius; and
b) a controller adapted to perform the method according to any of the preceding claims.

12. The coater for coating a substrate according to claim 11, wherein the cathode arrangement includes at least four rotatable cathodes, and wherein the distance between at least two of the at least four rotatable cathodes is different from the distance between at least further two of the at least four rotatable cathodes.

## Patentansprüche

1. Verfahren zum Beschichten eines Substrats mittels einer Kathodenanordnung, die mindestens zwei drehbare, zylindrische Kathoden enthält, wobei das Verfahren umfasst:
a) Drehen von mindestens einer der mindestens zwei drehbaren Kathoden in einer ersten Richtung; und,
b) zur selben Zeit, Drehen von mindestens einer der mindestens zwei drehbaren Kathoden in einer zweiten Richtung;
wobei die erste Richtung entgegengesetzt zur zweiten Richtung ist; und
wobei die mindestens zwei drehbaren Kathoden ein erstes Paar von drehbaren Kathoden umfassen, wobei das erste Paar aus zwei benachbarten drehbaren Kathoden besteht, und ein benachbartes zweites Paar von drehbaren Kathoden, wobei das zweite Paar aus zwei benachbarten drehbaren Kathoden besteht,
wobei die Drehrichtung von einer der zwei drehbaren Kathoden des ersten Paares von drehbaren Kathoden entgegengesetzt zur Drehrichtung der anderen Kathode der zwei drehbaren Kathoden des ersten Paares von drehbaren Kathoden ist, und
wobei die drehbaren Kathoden auf einer Umfangslinie eines Bogens positioniert sind, der einen ersten Radius aufweist.

2. Verfahren nach Anspruch 1, wobei die Kathodenanordnung mindestens vier drehbare Kathoden umfasst.

3. Verfahren nach einem der vorherigen Ansprüche, wobei die Kathodenanordnung eine gerade Zahl von drehbaren Kathoden umfasst, wobei eine erste Hälfte der mindestens zwei drehbaren Kathoden in der ersten Richtung gedreht wird, und eine zweite Hälfte der mindestens zwei drehbaren Kathoden in der zweiten Richtung gedreht wird.

4. Verfahren nach einem der Ansprüche 2-3, wobei die mindestens vier drehbaren Kathoden abwechselnd in entgegengesetzten Richtungen gedreht werden.

5. Verfahren nach einem der Ansprüche 2-4, wobei der Abstand zwischen mindestens zwei benachbarten drehbaren Kathoden sich von dem Abstand zwischen mindestens zwei anderen benachbarten drehbaren Kathoden unterscheidet.

6. Verfahren nach einem der vorherigen Ansprüche, wobei die Drehrichtung von einer der zwei drehbaren Kathoden des zweiten Paares von drehbaren Kathoden entgegengesetzt zur Drehrichtung der anderen Kathode der zwei drehbaren Kathoden des zweiten Paares von drehbaren Kathoden ist.

7. Verfahren nach einem der Ansprüche 1 bis 6, wobei der Abstand der zwei drehbaren Kathoden des ersten Paares von drehbaren Kathoden und optional der Abstand der zwei drehbaren Kathoden des zweiten Paares von drehbaren Kathoden sich vom Abstand zwischen dem ersten Paar von drehbaren Kathoden und dem zweiten Paar der drehbaren Kathoden unterscheidet.

8. Verfahren nach einem der Ansprüche 1 bis 7, wobei der Abstand der zwei drehbaren Kathoden des ersten Paares von drehbaren Kathoden und der Abstand der zwei drehbaren Kathoden des zweiten Paares von drehbaren Kathoden identisch ist.

9. Verfahren nach einem der vorherigen Ansprüche, wobei die mindestens zwei drehbaren Kathoden jeweils mindestens eine Magnetanordnung umfassen, die darin positioniert ist, wobei das Verfahren ferner umfasst:
a) Positionieren der Magnetanordnung in Bezug auf die drehbare Kathode in einer ersten Position, sodass die Magnetanordnung mit Bezug auf eine Ebene, die sich senkrecht vom Substrat bis zur Achse der drehbaren Kathode erstreckt, für ein vorgegebenes erstes Zeitintervall asymmetrisch ausgerichtet ist; und
b) Bewegen der Magnetanordnung in eine zweite Position, die ebenfalls mit Bezug auf die Ebene asymmetrisch ausgerichtet ist, und Halten der Magnetanordnung in der zweiten Position über ein vorgegebenes zweites Zeitintervall.

10. Verfahren nach Anspruch 10, wobei die Magnetanordnungen jeder drehbaren Kathode des ersten Paares von drehbaren Kathoden und/oder des zweiten Paares von drehbaren Kathoden synchron positioniert und bewegt werden.

11. Beschichtungsvorrichtung zum Beschichten eines Substrats, umfassend:
a) eine Kathodenanordnung, die mindestens zwei drehbare Kathoden enthält, welche auf einer Bogenumfangslinie positioniert sind, die einen ersten Radius aufweist; und
b) einen Controller, der dafür ausgelegt ist, das Verfahren nach einem der vorherigen Ansprüche auszuführen.

12. Beschichtungsvorrichtung zum Beschichten eines Substrats nach Anspruch 11, wobei die Kathodenanordnung mindestens vier drehbare Kathoden umfasst, und wobei der Abstand zwischen mindestens zwei der mindestens vier drehbaren Kathoden sich vom Abstand zwischen mindestens weiteren zwei der mindestens vier drehbaren Kathoden unterscheidet.

## Revendications

1. Procédé pour revêtir un substrat au moyen d'un agencement de cathodes incluant au moins deux cathodes cylindriques rotatives, le procédé comprenant :
a) de faire tourner au moins une des au moins deux cathodes rotatives dans une première direction ; et
b) en même temps, de faire tourner au moins une des au moins deux cathodes rotatives dans une seconde direction ;
dans lequel la première direction est opposée à la seconde direction ; et
dans lequel les au moins deux cathodes rotatives incluent une première paire de cathodes rotatives, dans lequel la première paire consiste en deux cathodes rotatives voisines, et une seconde paire voisine de cathodes rotatives, dans lequel la seconde paire consiste en deux cathodes rotatives voisines, dans lequel la direction de rotation de l'une des deux cathodes rotatives de la première paire de cathodes rotatives est opposée à la direction de rotation de l'autre des deux cathodes rotatives de la première paire de cathodes rotatives, et
dans lequel les cathodes rotatives sont positionnées sur une ligne circonférentielle d'un arc incluant un premier rayon.

2. Procédé selon la revendication 1, dans lequel l'agencement de cathodes inclut au moins quatre cathodes rotatives.

3. Procédé selon l'une quelconque des revendications précédentes, dans lequel l'agencement de cathodes inclut un nombre pair de cathodes rotatives, dans lequel une première moitié des au moins deux cathodes rotatives est tournée dans la première direction et une seconde moitié des au moins deux cathodes rotatives est tournée dans la seconde direction.

4. Procédé selon l'une quelconque des revendications 2-3, dans lequel les au moins quatre cathodes rotatives sont tournées dans des directions opposées en alternance.

5. Procédé selon l'une quelconque des revendications 2-4, dans lequel la distance entre au moins deux cathodes rotatives voisines diffère de la distance entre au moins deux autres cathodes rotatives voisines.

6. Procédé selon l'une quelconque des revendications précédentes, dans lequel la direction de rotation d'une des deux cathodes rotatives de la seconde paire de cathodes rotatives est opposée à la direction de direction de l'autre des deux cathodes rotatives de la seconde paire de cathodes rotatives.

7. Procédé selon l'une quelconque des revendications 1 à 6, dans lequel la distance des deux cathodes rotatives de la première paire de cathodes rotatives et optionnellement la distance des deux cathodes rotatives de la seconde paire de cathodes rotatives diffère de la distance entre la première paire de cathodes rotatives et la seconde paire de cathodes rotatives.

8. Procédé selon l'une quelconque des revendications 1 à 7, dans lequel la distance des deux cathodes rotatives de la première paire de cathodes rotatives et la distance des deux cathodes rotatives de la seconde paire de cathodes rotatives est identique.

9. Procédé selon l'une quelconque des revendications précédentes, dans lequel les au moins deux cathodes rotatives incluent chacune au moins un ensemble d'aimant positionné à l'intérieur, le procédé comprenant en outre :
a) de positionner l'ensemble d'aimant par rapport à la cathode rotative à une première position de façon à ce que l'ensemble d'aimant soit aligné de façon asymétrique par rapport à un plan s'étendant perpendiculairement du substrat vers l'axe de la cathode rotative pendant un premier intervalle de temps prédéterminé ; et
b) de déplacer l'ensemble d'aimant à une seconde position qui est également alignée de façon asymétrique par rapport audit plan et de maintenir l'ensemble d'aimant à la seconde position pendant un second intervalle de temps prédéterminé.

10. Procédé selon la revendication 10, dans lequel les ensembles d'aimant dans chaque cathode rotative de la première paire de cathodes rotatives et/ou de la seconde paire de cathodes rotatives sont positionnés et déplacés de manière synchrone.

11. Une installation de revêtement pour revêtir un substrat, comprenant :
a) un agencement de cathode incluant au moins deux cathodes rotatives positionnées sur une ligne circonférentielle d'un arc incluant un premier rayon ; et
b) une commande adaptée pour exécuter le procédé selon l'une quelconque des revendications précédentes.

12. L'installation de revêtement pour revêtir un substrat selon la revendication 11, dans lequel l'agencement de cathodes inclut au moins quatre cathodes rotatives, et dans lequel la distance entre au moins deux des au moins quatre cathodes rotatives est différente de la distance entre au moins deux autres des au moins quatre cathodes rotatives.
